Europäisches Patentamt

(19) European Patent Office

Office européen des brevets

(11) Veröffentlichungsnummer: **0 004 899**
**B1**

(12) **EUROPÄISCHE PATENTSCHRIFT**

(45) Veröffentlichungstag der Patentschrift:
**18.11.81**

(21) Anmeldenummer: **79101006.9**

(22) Anmeldetag: **03.04.79**

(51) Int. Cl.³: **H 01 R 9/09,** H 01 R 23/68,
H 01 R 33/76, H 05 K 3/32

(54) **Verfahren zur Herstellung elektrisch leitender und schwingungssicherer Verbindungen zwischen gedruckten Rückwandverdrahtungen von Leiterplatten und Kontaktfedern einer Federleiste, sowie hierfür geeignete Federleiste.**

(30) Priorität: **21.04.78 CH 4318/78**

(43) Veröffentlichungstag der Anmeldung:
**31.10.79 Patentblatt 79/22**

(45) Bekanntmachung des Hinweises auf die Patenterteilung:
**18.11.81 Patentblatt 81/46**

(84) Benannte Vertragsstaaten:
**FR GB SE**

(56) Entgegenhaltungen:
**DE-A-1 914 489**
**DE-A-2 429 714**
**DE-A-2 545 505**
**DE-A-2 730 127**

(73) Patentinhaber: **ERNI Elektroapparate GmbH,
Seestrasse 9, D-7321 Adelberg (Württ.) (DE)**

(72) Erfinder: **Czeschka, Franz, Talstrasse 7,
D-7324 Rechberghausen (DE)**

(74) Vertreter: **Seemann, Norbert W., Brehmstrasse 37,
D-7320 Göppingen (DE)**

Verfahren zur Herstellung elektrisch leitender und schwingungssicherer Verbindungen zwischen gedruckten Rückwandverdrahtungen von Leiterplatten und Kontaktfedern einer Federleiste sowie hierfür geeignete Federleiste.

Die Erfindung bezieht sich auf ein Verfahren zum Herstellen elektrisch leitender und schwingungssicherer Verbindungen zwischen gedruckten Rückwandverdrahtungen von Leiterplatten und Kontaktfedern einer Federleiste, bei dem mehrere Kontaktfedern gemeinsam in Form einer oder mehrerer Aufreihungen voneinander beabstandet und parallel zueinander innerhalb der Federleiste verschiebungssicher gehalten werden, bei dem die freien Enden von Wickelpfosten der gemeinsam gehalterten Kontaktfedern soweit in durchkontaktierte Bohrungen mindestens einer beidseitig kaschierten Leiterplatte eingeschoben werden, bis am anderen Ende der Wickelpfosten angeordnete Verbreiterungen der Kontaktfedern am Lochrand der Bohrungen anliegen und bei dem anschliessend die Verbreiterungen in die Bohrungen eingepresst werden, sowie auf eine hierfür geeignete Federleiste.

In der Elektronik findet die sogenannte Systembauweise seit einiger Zeit immer mehr Verbreitung, wobei moderne Geräte nach der steckbaren Modultechnik gefertigt werden. Die Verbindung der einzelnen Module, z.B. in Form von Leiterplatten, erfolgt dabei über Steckverbinder bzw. Federleisten und auf der Rückseite der zugehörigen Elemente über eine aufzubringende Verdrahtung. Neben der bereits lange bekannten Handlöttechnik haben sich weitere Verfahren zur Erstellung derartiger Rückwandverdrahtungen durchgesetzt, wie z.B. die Drahtwickeltechnik oder auch «WIRE WRAP» genannt, die sogenannte Klammertechnik oder aber die als «Motherboardtechnik» bezeichnete Leiterplatten-Rückwandverdrahtung.

Bei der bekannten «Motherboardtechnik» wird die elektrische Verbindung über Leiterzüge einer gedruckten Schaltung, die als Rückwandverdrahtung ausgelegt ist, hergestellt, wobei diese sowohl die mechanische Arretierung als auch die Fixierung der Steckverbinder übernimmt; der elektrische Kontakt zwischen gedruckter Schaltung und Steckverbinder wird mittels Weichlötung hergestellt.

Bekannt ist es bereits auch, Einzelkontakte mittels entsprechender Pressitze in durchkontaktierte Bohrungen der Leiterplatten einzeln einzupressen, was jedoch äusserst zeit- und damit kostenaufwendig ist und zudem noch zu Fehlerbildung neigt.

Aufgabe der vorliegenden Erfindung ist daher, ein Verfahren und eine zur Durchführung dieses Verfahrens speziell und im Detail geeignete Federleiste zu schaffen, mittels derer bei durch Aufdruck rückwandverdrahteter und durchkontaktierter Leiterplatten, in einfacher Weise und ohne aufwendige Fertigung- bzw. Montageverfahren eine gleichzeitig vibrations-, korrosions- und funktionssichere, Verbindung hergestellt werden kann.

Gelöst wird diese Aufgabe dabei im wesentlichen dadurch, dass die gemeinsame Haltung der Kontaktfedern in einer Halterungsleiste mit zwei senkrecht zu den Wickelpfosten verlaufenden Auflageflächen erfolgt, dass über die bis zu den Verbreiterungen eingeführten Kontaktfedern ein Federleistengehäuse derart gestülpt wird, dass im Inneren des Federleistengehäuses vorgesehene Anlageteile sich auf der oberen Auflagefläche der Halterungsleiste abstützen und, dass zum Einpressen der Verbreiterungen ein Stempel einer Einpressvorrichtung auf die Oberseite des Federleistengehäuses einwirkt.

Aus der DE-A-1914489 ist es über den ersten Teil des Anspruchs 1 hinaus bekannt, dass der Übergang vom Wickelpfosten zu der als Einpressanschluss dienenden Verbreiterung jeder Kontaktfeder stetig verläuft. Aus der DE-A-2429714 ist ein Verfahren zum Herstellen elektrisch leitender und schwingungssicherer Verbindungen zwischen gedruckten Rückwandverdrahtungen von Leiterplatten und Kontaktfedern einer Federleiste bekannt, bei dem die gemeinsame Halterung der Kontaktfedern in einer Halterungsleiste mit zwei senkrecht zu den Wickelpfosten verlaufenden Auflageflächen erfolgt.

Die zur Durchführung des Verfahrens geeignete, erfindungsgemässe Federleiste ist im Anspruch 2 und ihre besonderen Ausführungsarten sind in den weiteren Unteransprüchen angegeben.

Die einzelnen, erfindungsgemässen Verfahrensschritte, ihre Vorteile und die zur Verfahrensdurchführung speziell geeigneten, baulichen Elemente werden anhand der Zeichnungen im folgenden näher erläutert.

Es zeigen:

Fig. 1 eine Kontaktfeder perspektivisch in Ansicht,
Fig. 2 und 3 ebenfalls in perspektivischer Darstellung die einzelnen Verfahrensschritte,
Fig. 4 eine fertige Verbindung im Schnitt,
Fig. 5 in starker Vergrösserung den Querschnitt einer Kontaktstelle und
Fig. 6 ein Federleistengehäuse in teilweise geschnittener Seitenansicht.

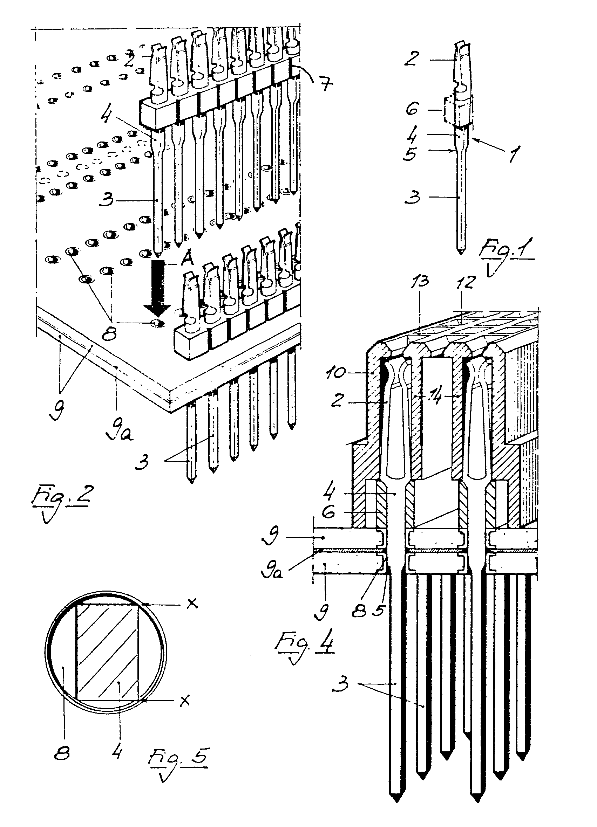

Die in Fig. 1 dargestellte Kontaktfeder 1 besteht aus dem Federkontakt 2, dem Wickelpfosten 3 und der als Einpressanschluss dienenden Verbreiterung 4 mit stetem, vorzugsweise parabolischem Übergang 5.

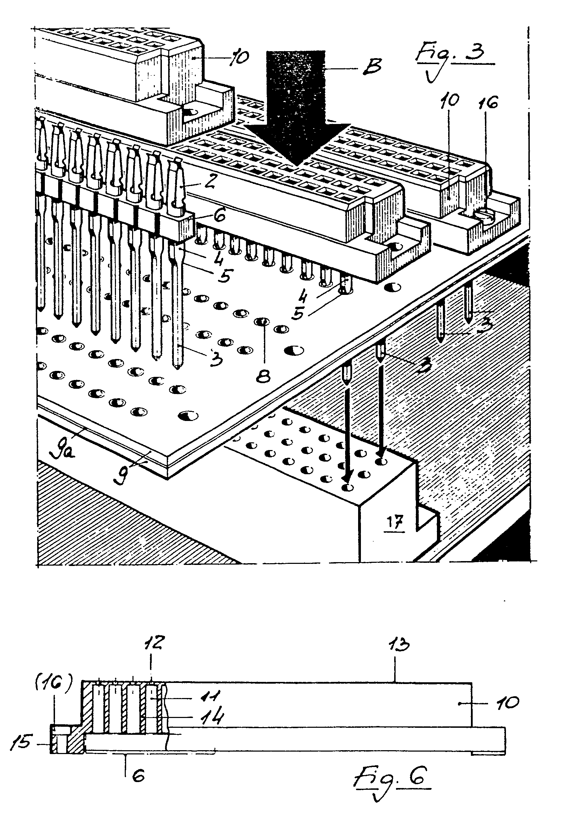

Wie Fig. 2 zeigt sind mehrere dieser Kontaktfedern 1 über eine Halterung 6 zu einer Art Leiste zusammengefasst; diese Leiste kann dabei durch Umspritzen der Teile 1 mit Kunststoff gebildet und mit Sollbruchstellen 7 versehen werden, um eine jeweils beliebige bzw. notwendige Anzahl von Kontakten durch einfaches Abbrechen eines entsprechenden Stückes von der Leiste schaffen zu können. Ein weiteres Grundelement für die Herstellung der erfindungsgemässen Verbindung ist mindestens eine, mit durchkontaktierten Bohrungen 8 versehene doppelt kaschierte, rückwandverdrahtete Leiterplatte 9; bei Verwendung von zwei oder mehreren dieser Platten 9 übereinander, muss jeweils eine Isolationsfolie 9a o.dgl. zwischengelegt werden. Drittes und letztes der Grundelemente ist schliesslich noch ein speziell gestaltetes Federleistengehäuse 10, welches später noch näher im Detail beschrieben wird.

Fig. 2 und Fig. 3 veranschaulichen gemeinsam das erfindungsgemässe Verfahren in seinen einzelnen Schritten: Eine oder mehrere der Leisten 6 werden gemäss Pfeil A soweit in die Bohrungen 8 eingesteckt, bis die als Einpressanschlüsse dienenden Verbreiterungen 4 sich an den Lochrand anlegen. Danach wird das Federleistengehäuse 10 aufgestülpt, das gemäss Fig. 6 derart gestaltet bzw. bemessen ist, dass von der Gehäuseoberseite 13 im Inneren ausgehende Stege 14 o.dgl. einerseits auf den Leisten 6 aufliegen und zum anderen durch kreuzweise Anordnung zueinander Kammern 11 mit oberen Öffnungen 12 bilden. Durch Aufbringen einer Presskraft gemäss Pfeil B auf die Gehäuseoberseite 13, was beispielsweise mit einem ebenflächigen Stempel einer Pressvorrichtung mit Gegenhalter 17 geschehen kann, werden die Verbreiterungen 4 nun in die durchkontaktierten Bohrungen 8 eingepresst, wobei die Stege 14 für eine gleichmässige Kraftweiterleitung, die parabolischen Übergänge 5 für ein gutes Eingleiten sorgen. Fig. 4 zeigt die Endlage der einzelnen Elemente zueinander, Fig. 5 in den Eckbereichen X die kontaktsichere Verbindung zwischen Einpressanschluss 4 und Bohrung 3. Zum Schluss wird schliesslich noch das Federleistengehäuse 10 im Flanschbereich 15 mittels Schrauben 16 gegenüber der oder den Leiterplatten 9 fixiert.

### Claims

1. Technique for production of electrically conductive and vibration-proof connections between the printed back-panel wiring of printed circuit boards (9, 9a) and the contact springs (1) of a multiple contact strip (6, 10), whereby sereval contact springs (1) are mutually fixed and safeguarded against displacement to form within the multiple contact strip one or several concatenations distanced from and parallel to each other, whereby the free ends of the winding posts (3) of the mutually fixed contact springs are pushed into through hole plated bores (8) of at least one both-side laminated, printed circuit board (9) until the enlargements (4) of the contact springs (1) arranged at the other end of the winding posts (3) sit close to the hole edge of the bores (8), and whereby the enlargements (4) are finally pressed into the bores, characterized in that way that mutual fixing of the contact springs (1) in a fixing strip (6) is effected by means of two seat engaging surfaces square to the winding posts (3), that a multiple contact strip enclosure (10) is put on the contact springs (1) introduced up to the enlargements (4) in such a way that put-on parts provided inside the multiple contact strip enclosure (10) are supported by the upper seat engaging surface of the fixing strip (6), and that for pressing in of the enlargements (4) a stamp of a press-in device is acting on the top (13) of the multiple contact strip enclosure (10).

2. Multiple contact strip suitable for realization of the technique as per claim 1, characterized in that way that the individual contact springs (1) are combined by an insulated fixing strip (6) to at least single-row contact strips, and that they are placed with a mutual distance in one or several parallel rows in the multiple contact strip enclosure (10), or are surrounded by the latter, in such a way that inside the enclosure several put-on parts proceeding from the top (18) of the multiple contact strip enclosure being in particular shaped as ridges (14) are lying on the upper seat engaging surface of each fixing strip (6).

3. Multiple contact strip as per claim 2, characterized in that way that the ridges (14) have a crosswise arrangement to each other, and are located between the contact springs (1), so forming chambers (11) for reception of always one contact spring (1).

4. Multiple contact strip as per claim 2 and 3, characterized in that way that the fixing strips (6) are connected with the contact springs (1) by means of injection moulded plastics, and a rated break point (7) is always located between two adjacent contact springs (1).

5. Multiple contact strip as per claim 2 to 4, characterized in that way that the transition (5) from the winding post (3) to the enlargement (4) of each contact spring (1) serving as press-in connection takes a steady, preferably parabolic course.

### Revendications

1. Procédé pour l'établissement de liaisons conductrices de l'électricité et à l'abri des oscillations entre des câblages imprimés de la paroi postérieure de plaques de circuits (9, 9a) et des ressorts de contact (1) d'une barrette de ressorts (6, 10), dans lequel plusieurs ressorts de contact (1) sont maintenus conjointement avec espacement entre eux et parallèlement entre eux sous la forme d'un ou plusieurs alignements, au sein de la barrette de ressorts, de manière à ne pas pouvoir se déplacer, dans lequel on insère les extrémités libres de piliers d'enroulement (3) des ressorts de contact maintenus conjointement dans des perforations métallisées (8) d'au moins une plaque de circuit doublée des deux côtés (9) jusqu'à ce que des élargissements (4) des ressorts de contact (1), situés à l'autre extrémité des piliers d'enroulement (3), s'appliquent contre le bord des perforations (8) et ensuite, on enfonce les élargissements (4) dans les perforations, caractérisé en ce que le maintien conjoint des ressorts de contact (1) s'effectue dans une barrette de monture (6) présentant deux surfaces d'appui perpendiculaires aux piliers d'enroulement (3), en ce que par dessus les ressorts de contact (1) introduits jusqu'aux élargissements (4), on glisse un boîtier de barrettes de ressorts (10), de façon telle que des parties d'application prévues à l'intérieur du boîtier de barrettes de ressorts (10) s'appuient sur la surface d'appui supérieur de la barrette de monture (6), et en ce que pour l'enfoncement des élargissements, un poinçon (B) d'un dispositif d'enfoncement agit sur le côté supérieur (13) du boîtier de barrettes de ressorts (10).

2. Barrette de ressorts convenant à la mise en œuvre du procédé selon la revendication 1, caractérisée en ce que les différents ressorts de contact (1) sont réunis par une barrette de monture isolante (6) en barrettes de contacts à au moins une rangée, et sont placés avec espacement mutuel en une ou plusieurs rangées parallèles dans le boîtier de barrettes de ressorts (10) ou entourées par celuici, de telle sorte qu'à l'intérieur du boîtier (18) du boîtier de barrettes de ressorts, et en particulier sous forme de nervures (14), reposent sur la surface d'appui supérieure de chaque barrette de monture (6).

3. Barrette de ressorts selon la revendication 2, caractérisée en ce que les nervures (14) ont une allure croisée les unes par rapport aux autres et sont placées entre les ressorts de contact (1) en formant des chambres (11) qui logent chacune un ressort de contact (1).

4. Barrette de ressorts selon les revendications 2 et 3, caractérisée en ce que les barrettes de monture (6) sont reliées aux ressorts de contact (1) par de la matière synthétique moulée par injection, qui les entoure, et entre deux ressorts de contact voisins (1) se trouve chaque fois une zone de rupture obligatoire (7).

5. Barrette de ressorts selon les revendications 2 à 4, caractérisée en ce que la transition (5) du pilier d'enroulement (3) à l'élargissement (4) de chaque ressort de contact (1), servant de connexion d'enfoncement, a une allure continue, de préférence parabolique.

**Patentansprüche**

1. Verfahren zum Herstellen elektrisch leitender und schwingungssicherer Verbindungen zwischen gedruckten Rückwandverdrahtungen von Leiterplatten (9, 9a) und Kontaktfedern (1) einer Federleiste (6, 10), bei dem mehrere Kontaktfedern (1) gemeinsam in Form einer oder mehrerer Aufreihungen voneinander beanstandet und parallel zueinander innerhalb der Federleiste verschiebungssicher gehaltert werden, bei dem die freien Enden von Wickelpfosten (3) der gemeinsam gehalterten Kontaktfedern soweit in durchkontaktierte Bohrungen (8) mindestens einer beidseitig kaschierten Leiterplatte (9) eingeschoben werden, bis am anderen Ende der Wickelpfosten (3) angeordnete Verbreiterungen (4) der Kontaktfedern (1) am Lochrand der Bohrungen (8) anliegen und bei dem anschliessend die Verbreiterungen (4) in die Bohrungen eingepresst werden, dadurch gekennzeichnet, dass die gemeinsame Halterung der Kontaktfedern (1) in einer Halterungsleiste (6) mit zwei senkrecht zu den Wickelpfosten (3) verlaufenden Auflageflächen erfolgt, dass über die bis zu den Verbreiterungen (4) eingeführten Kontaktfedern (1) ein Federleistengehäuse (10) derart gestülpt wird, dass im Innern des Federleistengehäuses (10) vorgesehene Anlageteile sich auf der oberen Auflagefläche der Halterungsleiste (6) abstützen und, dass zum Einpressen der Verbreiterungen (4) ein Stempel (B) einer Einpressvorrichtung auf die Oberseite (13) des Federleistengehäuses (10) einwirkt.

2. Federleiste, geeignet zur Durchführung des Verfahrens nach Anspruch 1, dadurch gekennzeichnet, dass die einzelnen Kontaktfedern (1), von einer isolierenden Halterungsleiste (6) zu mindestens einreihigen Kontaktleisten zusammengefasst, mit gegenseitigem Abstand in einer oder mehreren parallelen Reihen derart in dem Federleistengehäuse (10) liegen bzw. von diesem umgeben sind, dass im Gehäuseinneren mehrere von der Oberseite (18) des Federleistengehäuses ausgehende, insbesondere als Stege (14) ausgebildete Anlageteile auf der oberen Auflagefläche jeder Halterungsleiste (6) aufliegen.

3. Federleiste nach Anspruch 2, dadurch gekennzeichnet, dass die Stege (14) kreuzweise zueinander verlaufen und unter Bildung von jeweils eine Kontaktfeder (1) aufnehmender Kammern (11) zwischen den Kontaktfedern (1) liegen.

4. Federleiste nach den Ansprüchen 2 und 3, dadurch gekennzeichnet, dass die Halterungsleisten (6) durch Kunststoffumspritzen mit den Kontaktfedern (1) verbunden sind und jeweils zwischen zwei benachbarten Kontaktfedern (1) eine Sollbruchstelle (7) liegt.

5. Federleiste nach den Ansprüchen 2 bis 4, dadurch gekennzeichnet, dass der Übergang (5) vom Wickelpfosten (3) zu der als Einpressanschluss dienenden Verbreiterung (4) jeder Kontaktfeder (1) stetig, vorzugsweise parabolisch, verläuft.

Fig.1

Fig.2

Fig.4

Fig.5

Fig. 3

Fig. 6